# EUROPÄISCHE PATENTSCHRIFT

(11) **EP 2 221 894 B1**
(45) Veröffentlichungstag und Bekanntmachung des Hinweises auf die Patenterteilung: **22.10.2014**
(21) Anmeldenummer: 10154001.1
(22) Anmeldetag: 18.02.2010
(51) Int. Cl.: H01L 39/02, H01R 4/68

(54) **Supraleitende Verbindung von MgB2-Supraleiterdrähten über einen Presskörper aus HTS-Pulver**
Superconductive connection of MgB2 superconductor wires via a pressing body made of HTS powder
Connexion supraconductrice de fils supraconducteurs MgB2 par un comprimé en poudre HTS

(30) Priorität: 21.02.2009 DE 102009010011
(43) Veröffentlichungstag der Anmeldung: 25.08.2010
(73) Patentinhaber: Bruker EAS GmbH, 63450 Hanau (DE)
(72) Erfinder: Tenbrink, Felicitas, 63776 Mömbris (DE); Aubele, André, 63457 Hanau (DE); Glücklich, Volker, 63546 Hammersbach (DE); Sailer, Bernd, 63755 Alzenau (DE); Schlenga, Klaus, 76351 Linkenheim (DE)
(74) Vertreter: Kohler Schmid Möbus

(56) Entgegenhaltungen:
- EP-A2- 1 276 171
- GB-A- 2 448 051
- JP-A- 6 310 189

## Beschreibung

Die Erfindung betrifft ein Verfahren zur supraleitenden Verbindung von zwei oder mehr supraleitenden Drähten, die jeweils mindestens ein Filament enthaltend MgB₂ aufweisen,
wobei eine supraleitende Verbindung durch freigelegte Endbereiche der Filamente über eine supraleitende Matrix erfolgt,
und wobei eine Pulverschüttung eines Hochtemperatursupraleiter(=HTS)-Pulvers mit einer Sprungtemperatur T_{c} > 40 K bereitgestellt wird, in die die freigelegten Endbereiche der Filamente hineinragen, wobei das HTS-Material im HTS-Pulver vom Typ der Schichtcuprate ist.

Ein solches Verfahren ist aus der GB 2 448 051 A bekannt geworden.

Supraleiterdrähte, durch die ein elektrischer Strom verlustfrei fließen kann, werden in vielfältiger Weise eingesetzt, insbesondere für Hochfeld-Magnetspulen. Supraleitermaterialien werden dabei erst unterhalb einer materialspezifischen Sprungtemperatur T_{c} supraleitend, so dass Supraleitermaterialien für den technischen Einsatz gekühlt werden müssen. Eines der im technischen Einsatz wichtigsten Supraleitermaterialien ist NbTi, mit einer Sprungtemperatur von ca. 10 K. Da für diese niedrige Sprungtemperatur eine Kühlung mit kryogenem Helium (Siedepunkt ca. 4 K) erforderlich ist, ist der Einsatz von NbTi relativ teuer.

Im Jahre 2001 wurde Supraleitung im System Mg-B entdeckt, welches mit einer Sprungtemperatur von ca. 39 K für MgB₂ eine relativ kostengünstige Kühlung ohne kryogenes Helium zulässt. Dadurch könnten bei technischen Anlagen die Betriebskosten gesenkt und die Wartungsfreundlichkeit erhöht werden. Auch weist MgB₂ ein im Vergleich zu NbTi höheres kritisches Magnetfeld Bc2 auf. Daher ist das Supraleitersystem MgB₂ derzeit Gegenstand zahlreicher Forschungs- und Entwicklungsaktivitäten.

Eine Schwierigkeit im technischen Einsatz des MgB₂-Supraleitersystems besteht in der Bereitstellung von supraleitenden Verbindungsstellen ("Joints"), insbesondere zwischen zwei MgB₂-Supraleiterdrähten. Die Qualität der supraleitenden Verbindungsstellen begrenzt dabei die Leistungsfähigkeit des gesamten Supraleitersystems.

Aus der US 6,921,865 B2 ist ein Joint von zwei Supraleiterdrähten bekannt geworden, wobei freigelegte NbTi-Filamente der Supraleiterdrähte in eine Pulverschüttung von MgB₂ hineinragen und mit dieser verpresst werden.

Die DE 39 05 424 C2 beschreibt ein Verfahren zur Verbindung von oxidischen Supraleitern. Dabei werden deren Kontaktflächen thermisch verschmolzen.

Aus der US 7,226,894 B2 ist eine Verbindung von zwei MgB₂-Supraleiterdrähten bekannt geworden, bei der die MgB₂-Filamente an den Enden zweier Supraleiterdrähte freigelegt und in Überlappung gebracht werden. Die freigelegten Enden werden dann zusammen mit einer Mischung aus Borpulver und Magnesiumpulver erhitzt, wobei in einer chemischen Reaktion von Bor und Magnesium MgB₂ entsteht. Das entstandene MgB₂ dient der supraleitenden Verbindung der beiden Drähte. Das entstandene MgB₂ ist jedoch stark porös und die resultierende Stromtragfähigkeit des Joints ist relativ gering.

Die DE 10 2006 020 829 A1 beschreibt eine supraleitfähige Verbindung von Supraleiterdraht-Leiteradern, die beispielsweise aus MgB₂ bestehen können. Dabei werden freigelegte Leiterader-Enden in einer Hülse von einer Pulverschüttung von MgB₂ angeordnet. Die Pulverschüttung wird anschließend mitsamt der Hülse verpresst.

Die EP 0 280 812 B1 offenbart verschiedene Zusammensetzungen von Hochtemperatur-Supraleitern, insbesondere vom YBCO-Typ.

Die GB 2 448 051 A beschreibt ein supraleitendes Joint, bei dem Magnesiumdiborid-Filamente über Cupratmaterial miteinander verbunden werden. Im Joint-Bereich sind weiterhin Ausscheidungen beispielsweise aus Magnesiumoxyd angeordnet. Die Filamente sind entfernt voneinander angeordnet, gerade ineinander liegend angeordnet oder nach einer Abätzung etwa mit Salpetersäure zusammengeschoben.

### Aufgabe der Erfindung

Der Erfindung liegt die Aufgabe zugrunde, die Qualität, insbesondere Stromtragfähigkeit und kritische Magnetfeldstärke, einer supraleitenden Verbindung von MgB₂-Supraleiterdrähten zu verbessern.

### Kurze Beschreibung der Erfindung

Diese Aufgabe wird gelöst durch ein Verfahren der eingangs genannten Art, das dadurch gekennzeichnet ist, dass die freigelegten Endbereiche der Filamente der supraleitenden Drähte miteinander verflochten aneinander liegend in der Pulverschüttung angeordnet werden, und die Pulverschüttung mitsamt der hineinragenden, freigelegten Endbereiche der Filamente zu einem Presskörper verdichtet wird.

Die vorliegende Erfindung schlägt vor, die supraleitende Verbindung der supraleitenden Drähte über einen Presskörper aus HTS-Material herzustellen. Der quasi monolithische Presskörper aus HTS-Material wird während des Verbindungsprozesses der Supraleiterdrähte erzeugt.

Das HTS-Pulver umgibt die freigelegten (von ihrer nicht-supraleitenden Hülle befreiten) Endbereiche der MgB₂-Filamente, und erfüllt insbesondere einen etwaigen Zwischenraum zwischen den freigelegten Endbereichen. Durch die Verdichtung des HTS-Pulvers wird zuverlässig ein supraleitender Pfad mit hoher Stromtragfähigkeit zwischen den freigelegten Endbereichen hergestellt und verfestigt. Das HTS-Material ist bei der üblichen Betriebstemperatur der MgB₂-Filamente (mit Sprungtemperatur ca. 39 K) selbst auch supraleitend, da es eine höhere Sprungtemperatur (Sprungtemperatur > 40 K) als die MgB₂-Filamente aufweist.

Die Verdichtung des HTS-Pulvermaterials erfolgt durch mechanisches Verpressen. Typischerweise erfolgt das mechanische Verpressen dabei ohne eine Temperaturbeaufschlagung oder Beheizung. Insbesondere bleibt die Temperatur beim mechanischen Verpressen so gering, dass das Hochtemperatur-Supraleitermaterial (HTS-Material) nicht anschmilzt. Als Pressverfahren eignen sich insbesondere uniaxiales Pressen und isostatisches Pressen, insbesondere kaltisostatisches Pressen (CIP).

Gemäß der Erfindung ist vorgesehen, dass die freigelegten Endbereiche der Filamente der verschiedenen supraleitenden Drähte miteinander verflochten aneinander liegend in der Pulverschüttung angeordnet sind. Dadurch wird die Gefahr von schlecht leitenden Übergängen zwischen den Filamenten der verschiedenen Drähte vermindert, und der Zwischenraum zwischen Filamenten verschiedener Drähte wird gering gehalten. Mit Verdrillungen kann das Aneinanderliegen der Drähte auf einfache Weise sichergestellt werden. Die Verdrillung erfolgt am einfachsten solange die Filamente noch metallische Plastizität aufweisen (also vor einer Umwandlung von Mg und B in MgB₂).

Insgesamt stellt die Erfindung ein einfaches, im industriellen Alltag technisch problemlos umzusetzendes und kostengünstiges Verfahren zur Fertigung qualitativ hochwertiger Joints für die Verbindung von MgB₂-Supraleiterdrähten zur Verfügung.

### Bevorzugte Varianten der Erfindung

Bevorzugt ist eine Variante des erfindungsgemäßen Verfahrens, wobei die Pulverschüttung zur Verdichtung einer uniaxialen Pressung unterzogen wird. Uniaxiales Pressen ist besonders einfach durchzuführen.

Besonders bevorzugt ist eine Verfahrensvariante, bei der der Presskörper auf mindestens 30%, bevorzugt mindestens 40%, besonders bevorzugt mindestens 50%, der theoretischen Dichte des HTS-Materials des HTS-Pulvers verdichtet wird. Mit diesen Dichten können besonders hohe Stromtragfähigkeiten des Joints erreicht werden.

Bei einer vorteilhaften Verfahrensvariante enthält die Pulverschüttung zusätzlich einen Binder, insbesondere einen metallischen Binder. Der Binder kann das Pressverhalten und/oder die Festigkeit des Presskörpers verbessern. Der Binder liegt in der Pulverschüttung typischerweise pulverförmig vor, und umfasst bevorzugt elektrisch gut leitende Metalle wie Cu, Ag oder Al. Bei Verwendung eines Binders beträgt der Binderanteil typischerweise 10 bis 70 Volumen% in der Pulverschüttung.

Besonders vorteilhaft ist eine Verfahrensvariante, die vorsieht, dass die Pulverschüttung zur Verdichtung in einen plastisch verformbaren, insbesondere metallischen Behälter gefüllt wird, und der Behälter mit der Pulverschüttung verpresst wird, so dass nach der Verpressung der Presskörper in den Behälter dicht eingeschlossen ist. Durch den mitverpressten Behälter kann auf einfache Weise ohne zusätzlichen Fertigungsschritt der Presskörper vor mechanischen Beschädigungen, insbesondere vor einem Bruch der supraleitenden Verbindung zwischen den Supraleiterdrähten, geschützt werden. Der plastisch verformbare Behälter ist typischerweise erfindungsgemäß bei kryogenen Temperaturen, die zur Erreichung des supraleitenden Zustands des HTS und des MgB₂ notwendig sind, beständig.

Ebenfalls vorteilhaft ist eine Verfahrensvariante, bei der nach der Verdichtung der Presskörper in eine Schutzumhüllung eingebracht wird, insbesondere wobei der Presskörper in ein Kunststoffharz eingegossen wird. Die Schutzumhüllung schützt den Presskörper vor mechanischen Beschädigungen, insbesondere vor einem Bruch der supraleitenden Verbindung zwischen den Drähten. Dabei kann das Verpressen der HTS-Pulverschüttung in beliebiger Weise (ohne Rücksicht auf die Schutzumhüllung) erfolgen. Die Schützumhüllung kann anschließend an den Presskörper angepasst werden. Die Schutzumhüllung, insbesondere das Kunststoffharz, ist typischerweise erfindungsgemäß bei kryogenen Temperaturen, die zur Erreichung des supraleitenden Zustands des HTS und des MgB₂ notwendig sind, beständig.

Besonders bevorzugt ist eine Verfahrensvariante, bei der das HTS-Material im HTS-Pulver YBa₂Cu₃Oₓ oder ReBa₂Cu₃Oₓ oder Bi₂Sr₂CaCu₂Oₓ oder (Bi,Pb)₂Sr₂CaCu₂Ox oder (Bi,Pb)₂Sr₂Ca₂Cu₃Ox umfasst, mit Re: eines oder mehrere Seltenerdelemente. Diese HTS-Materialien weisen besonders hohe Stromtragfähigkeiten bei Joints von MgB₂-Supraleiterdrähten auf.

In den Rahmen der vorliegenden Erfindung fällt auch ein supraleitendes Joint, wobei das Joint hergestellt ist durch ein oben genanntes, erfindungsgemäßes Verfahren. Das verpresste HTS-Pulver stellt eine supraleitfähige Verbindung zwischen den supraleitenden Drähten bei der Betriebstemperatur von MgB₂ her. Das HTS-Material und damit auch das gesamte Joint weist eine sehr gute Stromtragfähigkeit auf.

Bevorzugt ist die supraleitende Matrix von einer Ummantelung umgeben. Die Ummantelung kann schon beim Verpressen eingerichtet worden sein (Behälter) oder auch nach dem Verpressen um den Presskörper angeordnet werden (Schutzumhüllung). Die Ummantelung kann insbesondere aus Metall gefertigt sein (etwa als ein Metallbehälter) oder auch ein Kunststoffharz, in das die supraleitende Matrix eingegossen ist, umfassen. Die Ummantelung hält dabei das verpresste HTS-Pulver dicht zusammen. Dadurch wird die supraleitende Verbindung sichergestellt und insbesondere ein Bruch der supraleitenden Verbindung verhindert.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Darstellung von Supraleiterdrähten, die mit dem erfindungsgemäßen Verfahren supraleitend verbunden werden sollen;
- Fig. 2: eine schematische Darstellung von Supraleiterdrähten, die mit dem erfindungsgemäßen Verfahren supraleitend verbunden werden sollen, mit verdrillten Filamenten;
- Fig. 3a, 3b: eine Presseinrichtung zum erfindungsgemäßen Verdichten einer HTS-Pulverschüttung mit hineinragenden, freigelegten Filamenten von zwei Supraleiterdrähten, vor dem Verdichten (Fig. 3a) und nach dem Verdichten (Fig. 3b), in schematischer Querschnittsdarstellung;
- Fig. 4: eine Presseinrichtung zum erfindungsgemäßen Verdichten einer HTS-Pulverschüttung mit hineinragenden, freigelegten Filamenten von zwei Supraleiterdrähten, wobei die HTS-Pulverschüttung in einen Metallbehälter eingeschlossen ist, vor dem Verdichten, in schematischer Querschnittsdarstellung;
- Fig. 5: den Metallbehälter von Fig. 4, nach dem Verdichten mit eingeschlossenem Presskörper, in schematischer Darstellung;
- Fig. 6: einen Presskörper, der gemäß der Erfindung in ein Kunststoffharz eingegossen ist, in schematischer Darstellung.

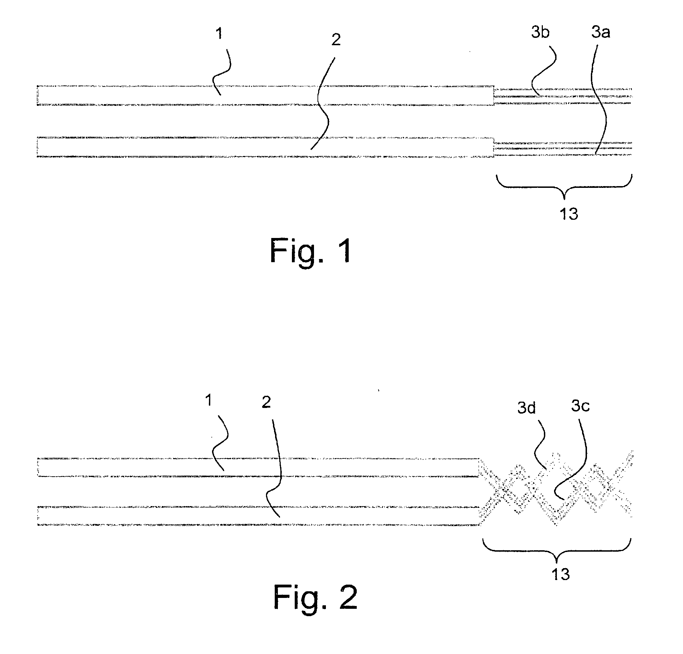

Die Figur 1 zeigt zwei Supraleiterdrähte 1, 2, die jeweils mehrere Filamente 3a, 3b enthaltend MgB₂ umfassen.

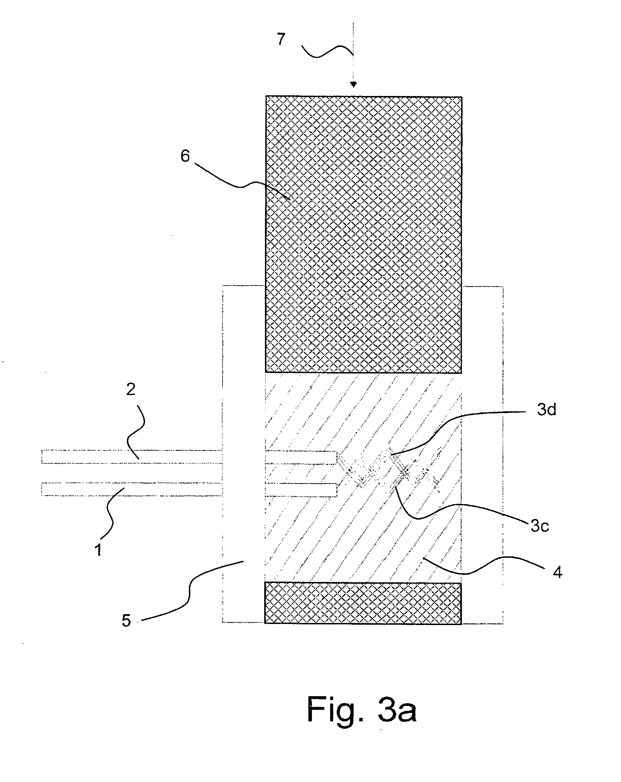

Die Filamente 3a, 3b sind jeweils in einem Endbereich 13 (in Fig. 1 rechtsseitig) freigelegt. Bei den dargestellten Drähten 1, 2 ist dazu im Endbereich 13 eine Ummantelung aus Monel, Fe, Nb, Ta, Ti, Edelstahl, Ni, Cu oder Cu-Legierung entfernt worden, etwa mittels Abätzen (Das Freilegen kann auch über andere chemische und/oder mechanische Verfahren erfolgen, etwa Abschleifen oder Anschleifen; es müssen dabei nicht zwingend alle Ummantelungen entfernt werden). Die Filamente 3a, 3b der beiden Drähte 1, 2 sollen mittels der Erfindung supraleitend verbunden werden, vgl. Figuren 3a bis 6. Dafür sollten die Filamente 3a, 3b der verschiedenen Drähte 1, 2 in unmittelbare Nähe zueinander gebracht werden.

Figur 2 zeigt ähnlich wie Figur 1 zwei Supraleiterdrähte 1, 2, die ebenfalls jeweils mehrere, in einem Endbereich 13 freigelegte Filamente 3c, 3d enthaltend MgB₂ aufweisen und mittels der Erfindung supraleitend verbunden werden sollen, vgl. Figuren 3a bis 6. Um die elektrische Leitung zwischen den Drähten 1, 2 im zu fertigenden Joint zu verbessern, wurden vorbereitend die Filamente 3c, 3d der beiden Supraleiterdrähte 1, 2 miteinander verdrillt.

Die Figuren 3a bis 6 illustrieren die erfindungsgemäße Fertigung eines Joints bzw. eines HTS-Pulverpresskörpers zwischen und um die Enden der zwei Drähte 1, 2.

Wie in Figur 3a dargestellt, sind die freigelegten Endbereiche der Filamente 3c, 3d der Drähte 1, 2 verdrillt und ragen in eine Pulverschüttung 4 hinein. Die Pulverschüttung füllt insbesondere Zwischenräume zwischen den freigelegten Filamenten 3c, 3d der verschiedenen supraleitenden, MgB₂-haltigen Drähte 1, 2 auf. Die Pulverschüttung 4 besteht im Wesentlichen aus feinkörnigem HTS-Pulver; ggf. sind weiterhin Hilfsstoffe (etwa Wachse oder Öle zur Verbesserung des Pressverhaltens oder Bindemittel, insbesondere metallische Binder, für eine verbesserte Festigkeit des Presskörpers) enthalten. Die Pulverschüttung 4 ist in einer Pressform 5 vorgelegt, die eine Durchführung für die beiden Drähte 1, 2 in ihrer seitlichen Wandung aufweist.

Durch Absenken eines Pressstempels 6 in Pfeilrichtung 7 auf die Pulverschüttung 4 kann die Pulverschüttung 4 mechanisch verdichtet werden. Zum Absenken des Pressstempels 6 wird typischerweise eine Kraft bereitstellende Hydraulik oder Mechanik eingesetzt. Der Pressvorgang erfolgt im ausgeführten Beispiel ohne Temperaturbeaufschlagung und benötigt auch keine Schutzgasbedingungen.

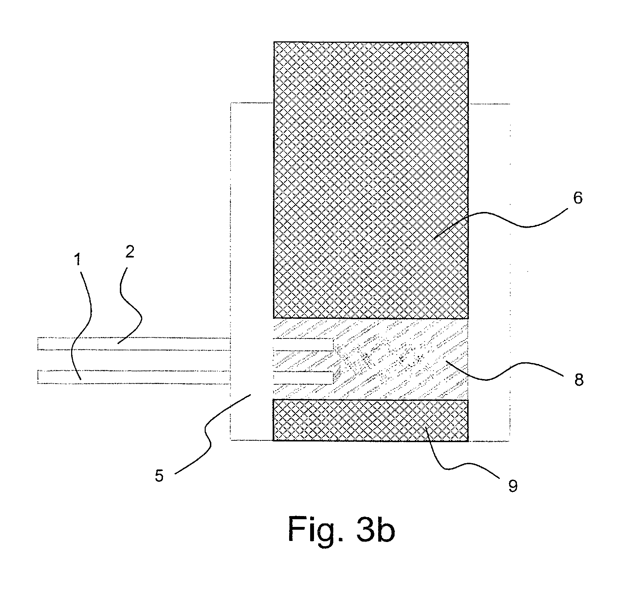

**Figur 3b** zeigt den Presskörper (auch genannt Grünkörper) 8 nach der Verdichtung der Pulverschüttung. Der Pressstempel 6 ist weitestgehend in die Pressform 5 eingefahren. Nach Entfernen des Pressstempels 6 (und meist auch des Pressenformbodens 9) kann der Presskörper 8 leicht entnommen werden.

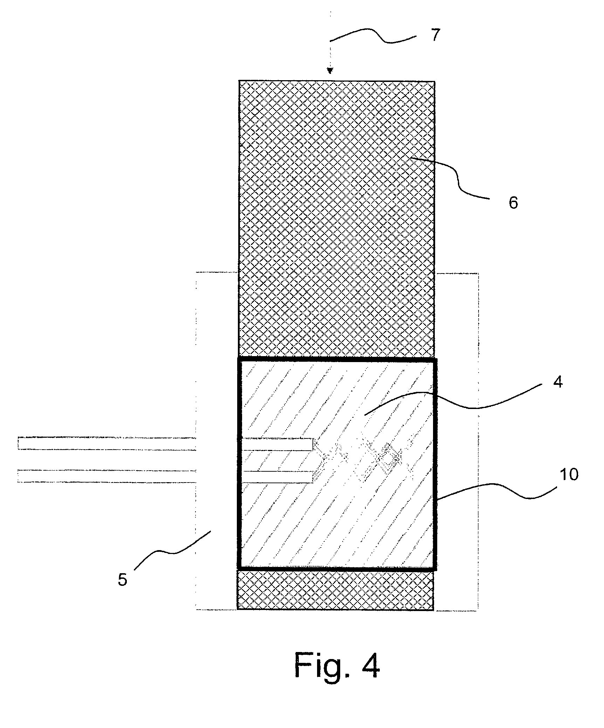

**Figur 4** illustriert eine erfindungsgemäße Variante des in den Figuren 3a, 3b dargestellten Pressverfahrens. Die Pulverschüttung 4 ist in dieser Variante in einen metallischen Behälter 10 eingeschlossen. Der Behälter 10 wird durch den in Pfeilrichtung 7 absinkenden Pressstempel 6 in der Pressform 5 mit verdichtet.

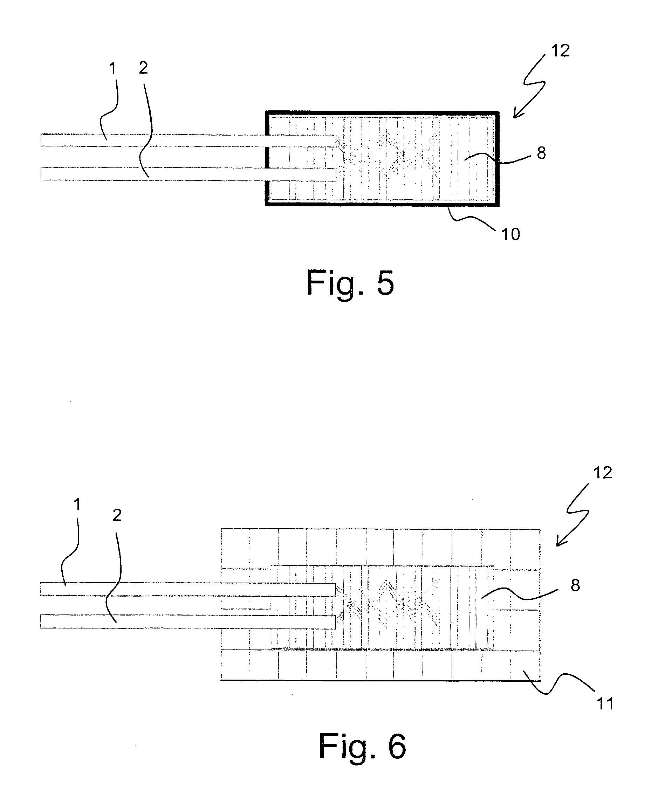

**Figur 5** zeigt einen Joint 12 als Ergebnis des in Fig. 4 dargestellten Pressverfahrens: Der Behälter 10 umschließt die verdichtete HTS-Pulverschüttung, also den Presskörper 8, allseitig, so dass kein HTS-Pulver aus dem Inneren des Behälters 10 entweichen kann. Die Drähte 1, 2 ragen aus dem Behälter 10 heraus. Der Behälter 10 hält den Presskörper 8 dicht zusammen. Dadurch wird sichergestellt, dass die durch den Pressvorgang eingerichteten supraleitenden Pfade durch geringfügige äußere Kräfte, wie sie bei einer normalen Handhabung auftreten, nicht aufbrechen können.

**Figur 6** zeigt einen weiteren erfindungsgemäßen Joint 12 mit einer Schutzumhüllung 11 für einen Presskörper 8, wie er beispielsweise nach dem in Fig. 3b dargestellten Pressvorgang erhalten wird. Der Presskörper 8 wurde nach dem Verpressen in ein Kunststoffharz eingegossen, das den Presskörper 8 als Schutzumhüllung 11 allseitig umgibt und so den Presskörper 8 dicht zusammenhält. Die Drähte 1, 2 ragen aus der Schutzumhüllung 11 heraus.

## Patentansprüche

1. Verfahren zur supraleitenden Verbindung von zwei oder mehr supraleitenden Drähten (1, 2), die jeweils mindestens ein Filament (3a-3b) enthaltend MgB₂ aufweisen,
wobei eine supraleitende Verbindung durch freigelegte Endbereiche (13) der Filamente (3a-3d) über eine supraleitende Matrix erfolgt,
und wobei eine Pulverschüttung (4) eines Hochtemperatursupraleiter(=HTS)-Pulvers mit einer Sprungtemperatur T_{c} > 40 K bereitgestellt wird, in die die freigelegten Endbereiche (13) der Filamente (3a-3d) hineinragen, wobei das HTS-Material im HTS-Pulver vom Typ der Schichtcuprate ist,
**dadurch gekennzeichnet, dass**
die freigelegten Endbereiche (13) der Filamente (3a-3d) der supraleitenden Drähte (1, 2) miteinander verflochten aneinander liegend in der Pulverschüttung (4) angeordnet werden,
und die Pulverschüttung (4) mitsamt der hineinragenden, freigelegten Endbereiche (13) der Filamente (3a-3d) zu einem Presskörper (8) verdichtet wird.

2. Verfahren nach Anspruch 1, **dadurch gekennzeichnet, dass** die Pulverschüttung (4) zur Verdichtung einer uniaxialen Pressung unterzogen wird.

3. Verfahren nach einem der vorhergehenden Ansprüche, **dadurch gekennzeichnet, dass** der Presskörper (8) auf mindestens 30%, bevorzugt mindestens 40%, besonders bevorzugt mindestens 50%, der theoretischen Dichte des HTS-Materials des HTS-Pulvers verdichtet wird.

4. Verfahren nach einem der vorhergehenden Ansprüche, **dadurch gekennzeichnet, dass** als Pulverschüttung (4) eine Pulverschüttung (4) eingesetzt wird, die zusätzlich einen Binder enthält, insbesondere einen metallischen Binder.

5. Verfahren nach einem der vorhergehenden Ansprüche, **dadurch gekennzeichnet, dass** die Pulverschüttung (4) zur Verdichtung in einen plastisch verformbaren, insbesondere metallischen Behälter (10) gefüllt wird,
und der Behälter (10) mit der Pulverschüttung (4) verpresst wird, so dass nach der Verpressung der Presskörper (8) in den Behälter (10) dicht eingeschlossen wird.

6. Verfahren nach einem der vorhergehenden Ansprüche, **dadurch gekennzeichnet, dass** nach der Verdichtung der Presskörper (8) in eine Schutzumhüllung (11) eingebracht wird,
insbesondere wobei der Presskörper (8) in ein Kunststoffharz eingegossen wird.

7. Verfahren nach einem der vorhergehenden Ansprüche, **dadurch gekennzeichnet, dass** eine Verdrillung der Filamente (3a-3d) erfolgt, solange diese noch metallische Plastizität aufweisen, nämlich vor einer Umwandlung von Mg und B in MgB₂.

8. Verfahren nach einem der vorhergehenden Ansprüche, **dadurch gekennzeichnet, dass** das HTS-Material im HTS-Pulver YBa₂Cu₃Oₓ oder ReBa₂Cu₃Oₓ oder Bi₂Sr₂CaCu₂Oₓ oder (Bi,Pb)₂Sr₂CaCu₂Oₓ oder (Bi,Pb)₂Sr₂Ca₂Cu₃Oₓ umfasst, wobei Re eines oder mehrere seltene Erdelemente ist.

9. Supraleitende Verbindungsstelle (12) hergestellt durch ein Verfahren nach einem der Ansprüche 1 bis 8.

## Claims

1. Method for superconductingly connecting two or more superconducting wires (1, 2), each comprising at least one filament (3a-3b) that contains MgB₂,
wherein a superconducting connection is realized through exposed end regions (13) of the filaments (3a-3d) via a superconducting matrix,
and wherein a bulk powder (4) of a high-temperature superconducting (HTS) powder with a transition temperature of T_{c}>40K is provided, into which the exposed end regions (13) of the filaments (3a-3d) project,
wherein the HTS material in the HTS powder is of the type of layered cuprates,
**characterized in that**
the exposed end regions (13) of the filaments (3a-3d) of the superconducting wires (1, 2) are disposed in the bulk powder (4) in such a fashion that they abut each other and are interwoven with each other,
and the bulk powder (4) is compacted together with the projecting exposed end regions (13) of the filaments (3a-3d) to form a compressed element (8).

2. Method according to claim 1, **characterized in that** the bulk powder (4) is subjected to uniaxial pressing for compaction.

3. Method according to any one of the preceding claims, **characterized in that** the compressed element (8) is compacted to at least 30%, preferably at least 40%, preferentially at least 50%, of the theoretical density of the HTS material of the HTS powder.

4. Method according to any one of the preceding claims, **characterized in that** a bulk powder (4) is used which additionally contains a binding agent, in particular a metallic binding agent.

5. Method according to any one of the preceding claims, **characterized in that** the bulk powder (4) is filled into a plastically deformable, in particular, metallic container (10) for compaction, and the container (10) is compressed with the bulk powder (4) such that after compression, the compressed element (8) is tightly enclosed in the container (10).

6. Method according to any one of the preceding claims, **characterized in that** the compressed element (8) is introduced into a protective coating (11) subsequent to compaction, in particular, wherein the compressed element (8) is cast into a plastic resin.

7. Method according to any one of the preceding claims, **characterized in that** the filaments (3a-3d) are twisted as long as the filaments still have their metallic plasticity, i.e. prior to conversion of Mg and B into MgB₂.

8. Method according to any one of the preceding claims, **characterized in that** the HTS material in the HTS powder comprises YBa₂Cu₃Oₓ or ReBa₂Cu₃Oₓ or Bi₂Sr₂CaCu₂Oₓ or (Bi,Pb)₂Sr₂CaCu₂Oₓ or (Bi,Pb)₂Sr₂Ca₂Cu₃Oₓ, wherein Re signifies one or more rare earth elements.

9. Superconducting joint (12) produced by a method according to any one of the claims 1 through 8.

## Revendications

1. Procédé pour la connexion supraconductrice de deux ou plus fils supraconducteurs (1, 2) qui présentent chacun au moins un filament (3a-3b) contenant du MgB₂, dans lequel une connexion supraconductrice est réalisée par des zones terminales dénudées (13) des filaments (3a-3d) via une matrice supraconductrice,
et dans lequel une charge pulvérulente (4) d'une poudre de supraconducteur à haute température (en anglais high-temperature superconductor = HTS) avec une température de transition T_{c} > 40 K est mise à disposition, dans laquelle s'enfoncent les zones terminales dénudées (13) des filaments (3a-3d), le matériau HTS de la poudre HTS étant du type cuprate en couche,
**caractérisé en ce que**
les zones terminales dénudées (13) des filaments (3a-3d) des fils supraconducteurs (1, 2) sont disposées l'une à côté de l'autre et entrelacées dans la charge pulvérulente (4),
et la charge pulvérulente (4) avec les zones terminales dénudées (13) des filaments (3a-3d) qui s'y enfoncent est compactée en un corps comprimé (8).

2. Procédé selon la revendication 1, **caractérisé en ce que** la charge pulvérulente (4) est soumise à une compression unixiale pour son compactage.

3. Procédé selon l'une des revendications précédentes, **caractérisé en ce que** le corps comprimé (8) est compacté à au moins 30 %, de préférence au moins 40 %, particulièrement de préférence au moins 50 % de la densité théorique du matériau HTS de la poudre HTS.

4. Procédé selon l'une des revendications précédentes, **caractérisé en ce qu'**on utilise comme charge pulvérulente (4) une charge pulvérulente (4) qui contient en plus un liant, en particulier un liant métallique.

5. Procédé selon l'une des revendications précédentes, **caractérisé en ce que**, pour le compactage, la charge pulvérulente (4) est mise dans un récipient (10) déformable plastiquement, en particulier métallique,
et le récipient (10) est comprimé avec la charge pulvérulente (4), de sorte qu'après la compression le corps comprimé (8) est enfermé de façon étanche dans le récipient (10).

6. Procédé selon l'une des revendications précédentes, **caractérisé en ce qu'**après le compactage, le corps comprimé (8) est introduit dans une enveloppe protectrice (11),
le corps comprimé (8) étant en particulier coulé dans une résine synthétique.

7. Procédé selon l'une des revendications précédentes, **caractérisé en ce qu'**un torsadage des filaments (3a-3d) est réalisé tant que ceux-ci présentent encore une plasticité métallique, à savoir avant une transformation de Mg et B en MgB₂.

8. Procédé selon l'une des revendications précédentes, **caractérisé en ce que** le matériau HTS de la poudre HTS comprend YBa₂Cu₃Oₓ ou ReBa₂Cu₃Oₓ ou Bi₂Sr₂CaCu₂Oₓ ou (Bi,Pb)₂Sr₂CaCu₂Oₓ ou (Bi,Pb)₂Sr₂Ca₂Cu₃Oₓ, où Re est un ou plusieurs éléments des terres rares.

9. Connexion supraconductrice (12) réalisée par un procédé selon l'une des revendications 1 à 8.
